# EUROPEAN PATENT APPLICATION

(11) **EP 3 340 405 A1**
(43) Date of publication of application: **27.06.2018**
(21) Application number: 17199567.3
(22) Date of filing: 01.11.2017
(51) Int. Cl.: H01S 5/028, H01S 5/065, H01S 5/10, H01S 5/12

(54) **SEMICONDUCTOR LASER, LIGHT SOURCE UNIT, COMMUNICATION SYSTEM, AND WAVELENGTH DIVISION MULTIPLEXING OPTICAL COMMUNICATION SYSTEM**

(30) Priority: 15.12.2016 JP 2016243534
(71) Applicant: Renesas Electronics Corporation, Tokyo 135-0061 (JP)
(72) Inventor: NOZU, Shunsuke, Koutou-ku, Tokyo 135-0061 (JP); MUROYA, Yoshiharu, Koutou-ku, Tokyo 135-0061 (JP)
(74) Representative: Moore, Graeme Patrick

(57) **Abstract**

Provided is a distributed feed back semiconductor laser including a phase shift part capable of obtaining an excellent single-mode yield and a high luminous efficiency. A diffraction grating (105) is formed so as to extend in a guiding direction of a resonator between an end surface at which a low reflective film (111) is formed and an end surface at which a high reflective film (110) is formed. In diffraction grating (105) a plurality of phase shift parts (106) that discontinuously change a phase of the diffraction grating (105) in a predetermined region separated from the end surface at which the low reflective film (111) is formed are disposed.

## Description

### CROSS-REFERENCE TO RELATED APPLICATIONS

This application is based upon and claims the benefit of priority from Japanese patent application No. 2016-243534, filed on December 15, 2016, the disclosure of which is incorporated herein in its entirety by reference.

### BACKGROUND

The present invention relates to a semiconductor layer, a light source unit, a communication system, and a wavelength division multiplexing optical communication system.

As one of the next-generation optical communication light sources, a distributed feed back (DFB) semiconductor laser has been developed. As an important design parameter for the DFB laser, kL, which is obtained by multiplying a resonator length L by a coupling coefficient k that is an index indicating a strength of coupling between guided light and a diffraction grating, is used. It is generally considered that the resonator length L is reduced and the parameter kL is increased (k is increased) to obtain a high-speed operation at 25 Gbps or higher, which is required for next-generation optical communication.

A DFB laser (e.g., Japanese Unexamined Patent Application Publication No. S61-216383) will be described. In a typical example of the DFB laser, a diffraction grating is disposed between a low-reflection end surface and a high-reflection end surface, and one phase shift part is disposed in a part of the diffraction grating. The diffraction grating is formed of, for example, a concave-convex structure including a guide layer and a clad layer which are formed on an active layer. The phase shift part is disposed as a λ/4 phase shift part in which the pitch of the diffraction grating is shifted by one-fourth of a wavelength λ. Accordingly, the DFB laser performs a single-mode oscillation at a wavelength in the vicinity of a Bragg wavelength determined by the period of the diffraction grating. Further, in the DFB laser including the phase shift part, the front end surface that outputs signal light is set as a low-reflection end surface and the back end surface that outputs monitor light is set as a high-reflection end surface, thereby obtaining the signal light more efficiently than when both of the end surfaces are set as low-reflection end surfaces, and obtaining a high light output and a high luminous efficiency.

However, it is difficult for the DFB laser having a high-reflection end surface to obtain an excellent single axis mode characteristic. One of the causes of this is that, in the DFB laser having one high-reflection end surface, an electric field strength distribution in a resonator and oscillation conditions for each mode vary due to variations of the phase of the diffraction grating at the high-reflection end surface.

On the other hand, in the semiconductor laser disclosed in Japanese Unexamined Patent Application Publication No. S61-216383, the phase shift part is disposed at an appropriate position in the resonator, thereby reducing the effect of variations of in the phase at the end surface and improving the single-mode yield.

### SUMMARY

However, in the DFB laser including the phase shift part disclosed in Japanese Unexamined Patent Application Publication No. S61-216383, the electric field strength distribution of the light along the axis direction of the resonator is not uniform. In general, as the electric field strength of the light increases, the recombination probability of carriers due to stimulated emission increases, so that a large number of carriers are consumed. Accordingly, spatial hole burning in which a carrier density in the resonator is not uniform occurs. The occurrence of such spatial hole burning is remarkable when a large current is flowed, and leads to destabilization of an oscillation mode during a modulation operation.

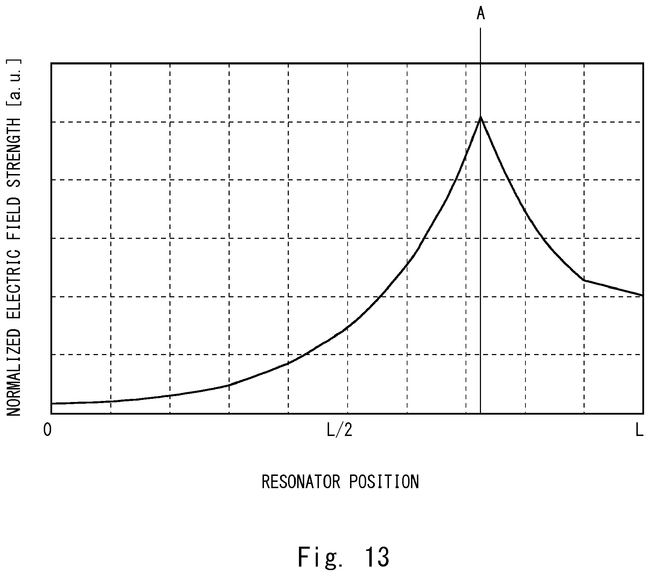

Fig. 13 shows a calculation result of an electric field strength distribution of a light when kL=2.1 in the DFB laser described above. In the electric field distribution shown in Fig. 13, it is obvious that the electric field strength of the light at a position A of the phase shift part corresponds to a peak. Specifically, when the parameter kL is increased to obtain a high light output, spatial hole burning is likely to occur in a region with a high electric field strength, which leads to the destabilization of the oscillation mode when a large current is flowed, and causes a multi-mode oscillation.

Further, in a region with a high electric field strength of the light , the deterioration of elements is accelerated due to a high light density, the number of random failures of elements due to a catastrophic optical damage (COD) increases, and the abrasion deterioration is accelerated, which may lead to deterioration of the element life.

As for the concentration of the electric field strength at such a position of the phase shift part, a technique of dispersing the electric field strength by disposing a plurality of phase shift parts is proposed. For example, Japanese Unexamined Patent Application Publication No. H01-239892 discloses a DFB laser in which both end surfaces are low reflective and a plurality of phase shift parts are disposed to smooth an electric field strength distribution. However, in the DFB laser in which both end surfaces are low-reflection end surfaces as disclosed in Japanese Unexamined Patent Application Publication No. H01-239892, a sufficiently high light output cannot be obtained, unlike in the DFB laser having a high-reflection end surface and a low-reflection end surface.

In addition, Japanese Unexamined Patent Application Publication No. H06-85398 discloses a structure in which a plurality of phase shifts are disposed in a DFB layer having a low-reflection end surface and a high-reflection end surface. However, in the DFB laser disclosed in Japanese Unexamined Patent Application Publication No. H06-85398, when a plurality of phase shift parts are disposed , an excellent single-mode yield cannot be obtained.

As described above, there is a demand for a distributed feed back semiconductor laser including a phase shift part with which an excellent single-mode yield and a high luminous efficiency can be obtained.

Other problems to be solved by and novel features of the present invention will become apparent from the following description and the accompanying drawings.

A distributed feed back semiconductor laser according to one embodiment includes: a first resonator end surface having a low reflectance; a second resonator end surface having a high reflectance; and a diffraction grating formed so as to extend in a guiding direction of a resonator. A plurality of phase shift parts configured to discontinuously change a phase of the diffraction grating are disposed in a predetermined range separated from the first resonator end surface in the diffraction grating.

According to the one embodiment, it is possible to provide a distributed feed back semiconductor laser including a phase shift part with which an excellent single-mode yield and a high luminous efficiency can be obtained.

### BRIEF DESCRIPTION OF THE DRAWINGS

The above and other aspects, advantages and features will be more apparent from the following description of certain embodiments taken in conjunction with the accompanying drawings, in which:
Fig. 1 is a diagram schematically showing a sectional configuration of a DFB laser according to a first embodiment;
Fig. 2 is a graph showing a calculation result of an electric field strength distribution of a light in the DFB laser according to the first embodiment;
Fig. 3 is a graph showing a result of a single-mode yield under conditions in which average threshold gain differences are different;
Fig. 4 shows a calculation result of a dependence of a threshold gain difference on a distance L1 when a distance L2 is 0.9×L;
Fig. 5 shows a calculation result of a dependence of a threshold gain difference on the distance L2 when the distance L1 is 0.5×L;
Fig. 6 is a graph showing a dependence of the threshold gain difference on the number of phase shifts;
Fig. 7 is a graph showing an example of a dependence of peak electric field strength on the number of phase shifts;
Fig. 8 schematically shows a sectional configuration of a DFB laser according to a second embodiment;
Fig. 9 shows an example of a calculation result of an electric field strength distribution of a light in the DFB laser according to the second embodiment;
Fig. 10 is a diagram schematically showing a configuration of a light source unit according to a third embodiment;
Fig. 11 is a diagram schematically showing a configuration of an optical communication system according to a fourth embodiment;
Fig. 12 is a diagram schematically showing a configuration of a wavelength division multiplexing optical communication system according to a fifth embodiment; and
Fig. 13 is a diagram showing a calculation result of an electric field strength distribution of a light when kL=2.1 in a typical DFB laser.

### DETAILED DESCRIPTION

Embodiments of the present invention will be described below with reference to the drawings. In the drawings, the same elements are denoted by the same reference numerals, and repeated explanations are omitted as appropriate.

### First Embodiment

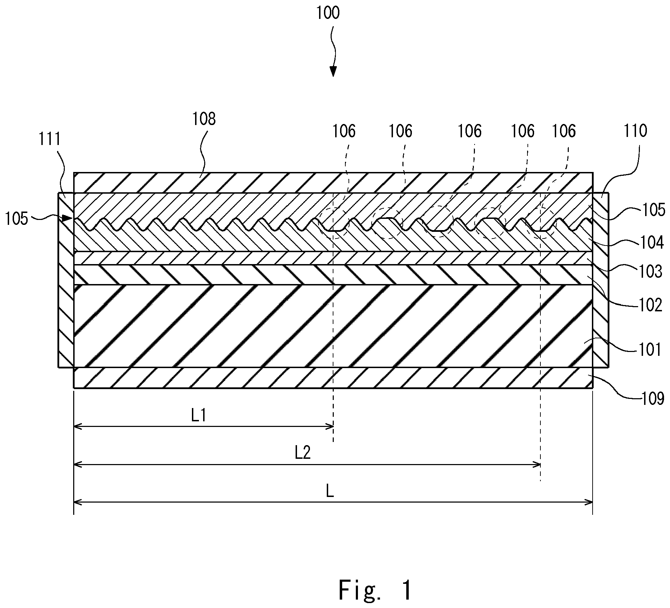

A distributed feed back (DFB) semiconductor laser according to a first embodiment will be described. A DFB laser 100 according to the first embodiment is configured as a semiconductor laser that is used in a 1.3 µm band or a 1.5 µm band and formed of an InP (indium phosphide) or InGaAsP (indium gallium arsenide phosphide)-based material. Fig. 1 schematically shows a sectional configuration of the DFB laser 100 according to the first embodiment.

The DFB laser 100 according to the first embodiment includes an n-type substrate 101, an n-type guide layer 102, an active layer 103, a p-type guide layer 104, a p-type clad layer 107, a p-electrode 108, an n-electrode 109, a high reflective film 110, and a low reflective film 111.

The n-type guide layer 102, the active layer 103, the p-type guide layer 104, and the p-type clad layer 107, which are semiconductor crystal layers, are sequentially stacked on the n-type substrate 101. The semiconductor crystal layers are stacked using, for example, a MOVPE (Metal-Organic Vapor Phase Epitaxy) method.

The p-electrode 108 is formed on the p-type clad layer 107. The p-electrode 108 can be formed by, for example, depositing a Cr/Au layer using vacuum evaporation or the like. The n-electrode 109 is formed on the back surface of the n-type substrate 101. The n-electrode 109 is formed by, for example, depositing an AuGe/Au layer using vacuum evaporation or the like.

At the resonator end surfaces in the guiding direction of the DFB laser 100 are formed, for example, by being cleaved in such a manner that a resonator length L of the DFB laser 100 is obtained. The low reflective film 111 and the high reflective film 110 for adjusting the reflectance at the resonator end surfaces are formed. The low reflective film 111 and the high reflective film 110 are formed by, for example, depositing an insulating film, such as Al₂O₃ or SiO₂, by sputtering. In this case, the reflectance of the low reflective film 111 is 5%, and the reflectance of the high reflective film 110 is 85%. Note that an end surface at which the low reflective film is formed is also referred to as a first resonator end surface and an end surface at which the high reflective film is formed is also referred to as a second resonator end surface.

A diffraction grating 105 and a phase shift part 106 which are disposed in the DFB laser 100 will be described below. The p-type guide layer 104 and the p-type clad layer 107 have a concave-convex structure and constitute the diffraction grating 105. The diffraction grating 105 is formed in such a manner that, for example, a concave-convex structure is formed by electron beam exposure and etching on the surface of the p-type guide layer 104, and is then buried by the p-type clad layer 107.

The period of the diffraction grating 105 is determined depending on the oscillation wavelength. For example, when the oscillation wavelength is 1.3 µm, the period of the diffraction grating 105 is approximately 200 nm. In this case, when the resonator length L in the guiding direction of the DFB laser 100 shown in Fig. 1 is 200 µm, approximately 1000 concave-convex structures of the diffraction grating are included in the resonator. In the first embodiment, the p-type guide layer and the p-type clad layer constitute the diffraction grating, but this structure is described by way of example only. The present invention is not limited to this structure.

The phase shift part 106 that discontinuously changes the phase of the diffraction grating 105 is disposed in the diffraction grating 105. The phase shift part 106 is a λ/4 phase shift part which is obtained by shifting the phase by an amount equal to 1/4 of the oscillation wavelength λ (1/2 of a diffraction grating period Λ). An odd number of phase shift parts 106 are formed. For example, the first embodiment is described assuming that five phase shift parts 106 are formed. In the DFB laser 100, each phase shift part 106 is disposed at a position separated from the low reflective film 111 between the center of the resonator and the high reflective film 110. Referring to Fig. 1, for example, each phase shift part 106 is disposed between the position where the distance from the low reflective film 111 is L1 and the position where the distance from the low reflective film 111 is L2. In this example, assume that when the entire length of the resonator is L, the distance L1 is 0.5 L or more (L1≥0.5×L) and the distance L2 is 0.9 L or less (L2≤0.9×L). For example, when the entire length L of the resonator is 200 µm, the distance L1 is 125 µm and the distance L2 is 165 µm.

The active layer 103 constitutes a multi quantum well (MQW) structure which is formed of AlGaInAs as disclosed in, for example, Japanese Unexamined Patent Application Publication No. H5-175597. Further, the active layer 103 is sandwiched between the n-type guide layer 102 and the p-type guide layer 104, thereby forming a double hetero structure. The double hetero structure is etched into a stripe shape, thereby forming a current blocking structure.

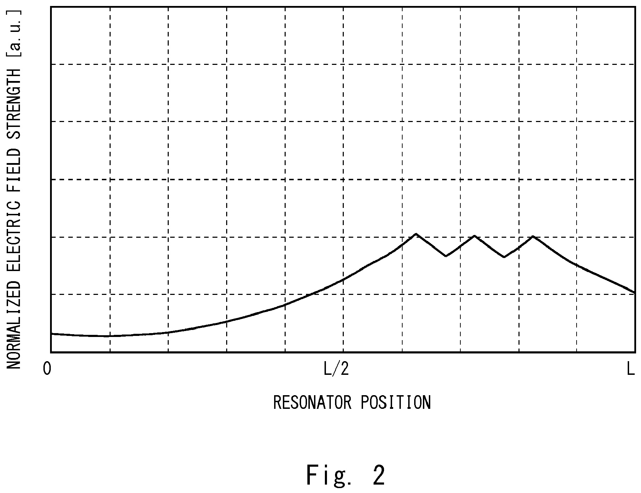

Next, the operation of the DFB laser 100 according to the first embodiment will be described. Fig. 2 shows an example of a calculation result of an electric field strength distribution of a light in the DFB laser 100 according to the first embodiment.

In the DFB laser 100, the electric field strength in each phase shift part 106 is suppressed and the peak of the electric field strength is equal to or less than a half of that in the case where only one phase shift part is disposed as described above (Fig. 13) . Thus, spatial hole burning is suppressed, and stable single-mode characteristics can be obtained even when a large current is flowed.

While Fig. 2 illustrates the calculation result when kL is 2.1, the suppression of the electric field strength is not limited by the value kL. Also, in a range of 1≤kL≤4, the electric field strength can be almost similarly suppressed at the position where the phase shift part 106 is disposed.

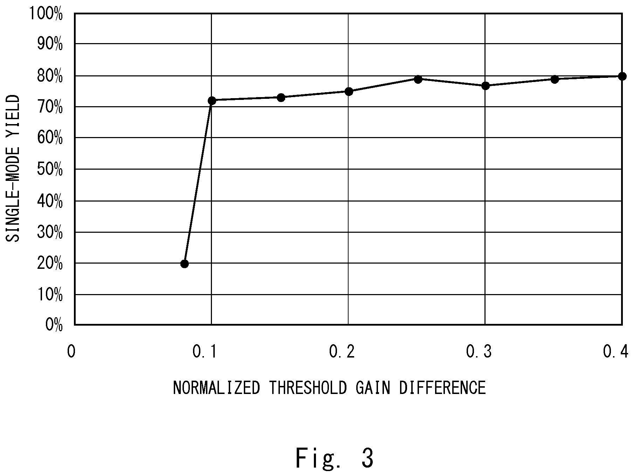

Next, effects of positions where a plurality of phase shift parts 106 are formed will be described with reference to Figs. 3 to 5. Fig. 3 shows a result of a single-mode yield under different conditions of an average threshold gain difference. When the threshold gain difference is less than 0.1, the single-mode yield rapidly deteriorates. Accordingly, in order to achieve stable production in consideration of production costs, it is necessary to set the threshold gain difference to 0.1 or more.

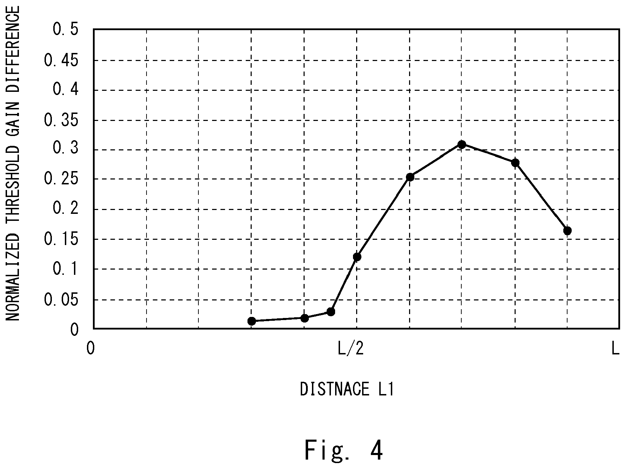

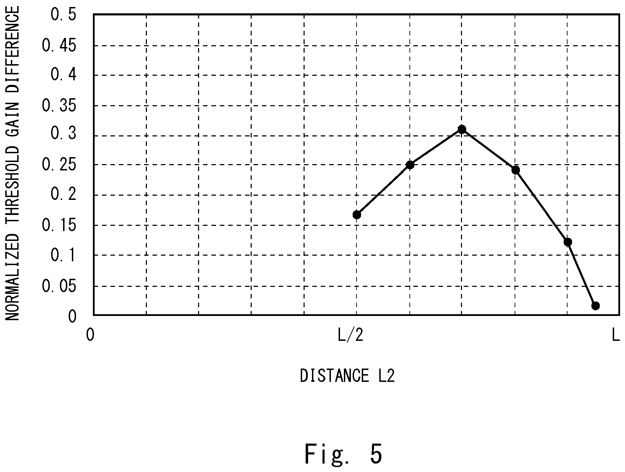

Fig. 4 shows a calculation result of a dependence of a threshold gain difference on the distance L1 when the distance L2 is 0.9×L. Fig. 5 shows a calculation result of a dependence of a threshold gain difference on the distance L2 when the distance L1 is 0.5×L. As seen from Figs. 4 and 5, when the distance L1 is 0.5×L or more and the distance L2 is 0.9×L or less, the threshold gain difference is 0.1 or more and thus an excellent single-mode yield can be stably obtained. Similar results can be obtained, for example, within a range of 50 µm ≤ L ≤ 300 µm, without depending on the value of the resonator length L. However, in consideration of the value kL, the resonator length L is desirably 200 µm.

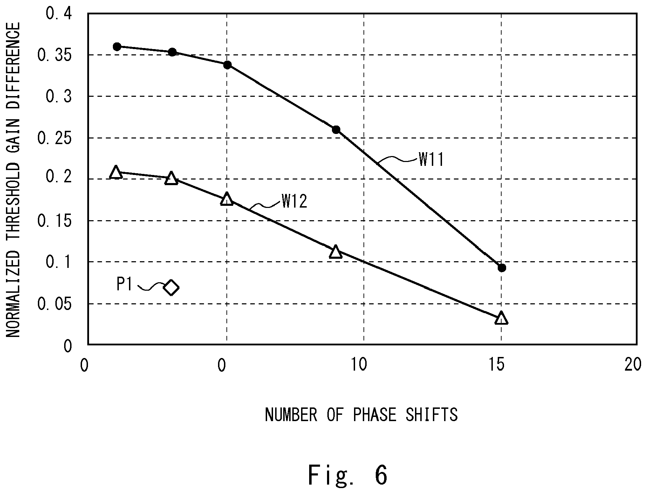

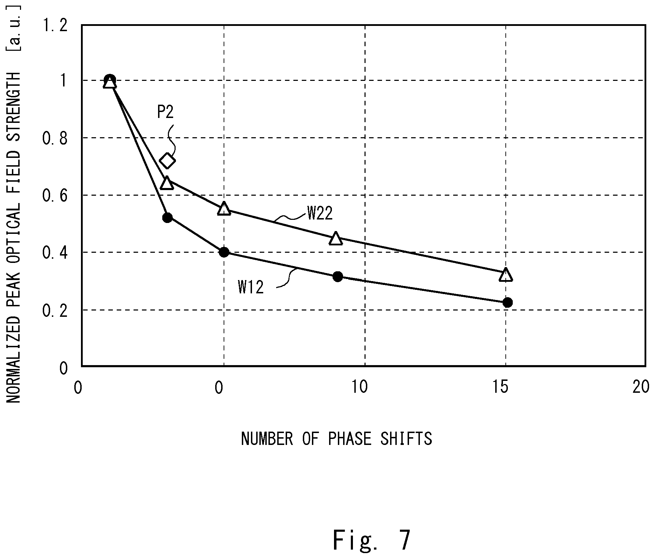

In the first embodiment, five phase shifts are used, but the number of phase shifts to be used is not limited to five. Fig. 6 shows a dependence of the threshold gain difference on the number of phase shifts. Fig. 7 shows an example of the dependence of the peak electric field strength on the number of phase shifts. Fig. 7 shows that the peak electric field strength is normalized assuming that the peak electric field strength is 1 when only one phase shift part is disposed. A waveform W11 shown in Fig. 6 and a waveform W12 shown in Fig. 7 indicate the calculation results in the DFB laser 100 according to the first embodiment.

As the number of phase shift parts increases, the peak electric field strength decreases and the threshold gain difference also decreases. Accordingly, in order to obtain a threshold gain difference of 0.1 or more and suppress the electric field strength, the number of phase shift parts to be disposed is desirably an odd number in a range from 3 to 13.

When an even number of phase shift parts are formed, an electric field strength distribution in which the electric field strength on the high reflective film 110 has a peak is obtained, and the effect of a variation in the phase of the diffraction grating at the high-reflective end surface is large, which leads to deterioration in the single-mode yield. Accordingly, the number of phase shift parts to be disposed is desirably an odd number.

Comparative examples when the phase shift of each phase shift part is λ/8 are respectively indicated by a waveform W21 shown in Fig. 6 and a waveform W22 shown in Fig. 7. In this case, the effect of suppressing the electric field strength is hardly obtained and the threshold gain difference is reduced, unlike in the waveform W11 and the waveform W12 each having a phase shift of λ/4. Accordingly, it is obvious that the phase shift in each phase shift part is desirably set to λ/4.

Further, as comparative examples, a threshold gain difference and normalized peak electric field strength of a light are calculated when three phase shift parts are disposed at the positions described in Japanese Unexamined Patent Application Publication No. H06-85398. An observation point P1 shown in Fig. 6 and an observation point P2 shown in Fig. 7 correspond to the threshold gain difference and the normalized peak electric field strength of the light, respectively. As indicated by the observation point P1 shown in Fig. 6 and the observation point P2 shown in Fig. 7, the concentration of the field strength can be suppressed. However, the threshold gain difference has a value less than 0.1. In general, in order to achieve an excellent single-mode yield, a threshold gain difference of 0.1 or more is required. Accordingly, it can be understood that a sufficient single-mode yield cannot be obtained by the DFB laser disclosed in Japanese Unexamined Patent Application Publication No. H06-85398.

As described above, according to this configuration, a plurality of phase shift parts are disposed between the center of the resonator and the resonator end surface at which a high reflective film is formed, thereby achieving a distributed feed back laser capable of obtaining stable single-mode characteristics and preventing random failures.

### Second Embodiment

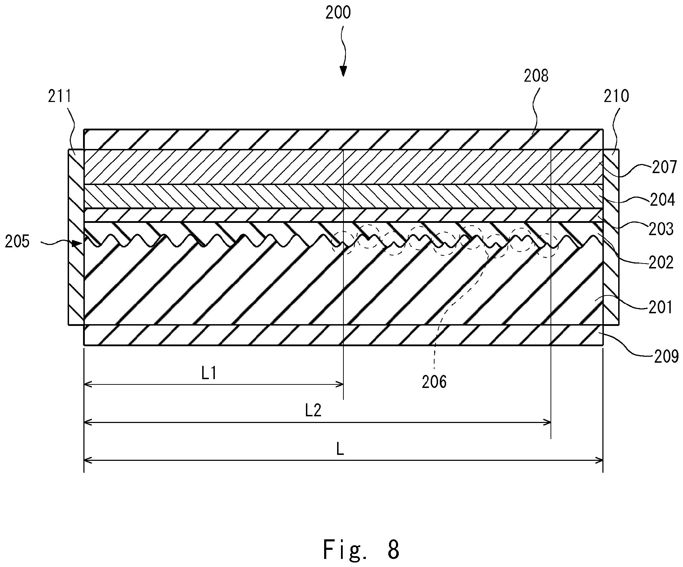

A DFB laser 200 according to a second embodiment will be described. Fig. 8 schematically shows a sectional configuration of the DFB laser 200 according to the second embodiment. An n-type substrate 201, an n-type guide layer 202, an active layer 203, a p-type guide layer 204, a p-type clad layer 207, a p-electrode 208, an n-electrode 209, a high reflective film 210, and a low reflective film 211 of the DFB laser 200 according to the second embodiment respectively correspond to the n-type substrate 101, the n-type guide layer 102, the active layer 103, the p-type guide layer 104, the p-type clad layer 107, the p-electrode 108, the n-electrode 109, the high reflective film 110, and the low reflective film 111 of the DFB laser 100 according to the first embodiment.

The DFB laser 200 according to the second embodiment differs from the DFB laser 100 according to the first embodiment in that a diffraction grating 205 is composed of the n-type substrate 201 and the n-type guide layer 202, and nine phase shift parts 206 are disposed. The other configuration of the DFB laser 200 is similar to that of the DFB laser 100, and thus the description thereof is omitted.

Note that in the second embodiment, the n-type substrate 201 and the n-type guide layer 202 constitute the diffraction grating 205. However, this configuration is described by way of example only, and other configurations may be employed. For example, as illustrated in the first embodiment, the p-type guide layer 204 and the p-type clad layer 207 may constitute the diffraction grating.

Further, in the second embodiment, the resonator length L is 120 µm; the distance L1 is 60 µm; and the distance L2 is 100 µm. However, the resonator length L and the distances L1 and L2 are not limited to these values.

The resonator length of the DFB laser 100 according to the first embodiment is 200 µm, while the resonator length of the DFB laser 200 according to the second embodiment is 120 µm, which is shorter than the resonator length of the DFB laser 100. In this case, when an optical output equivalent to that of the DFB laser 100 is obtained, problems such as destabilization of the single-mode caused by spatial hole burning due to the concentration of the electric field strength distribution, and deterioration of the element life become more noticeable. This is because the gain that can be obtained in a long resonator gain region needs to be obtained with a short resonator gain region. In other words, in the DFB laser having a resonator length, it is necessary to further suppress the concentration of the electric field strength as the resonator length becomes shorter.

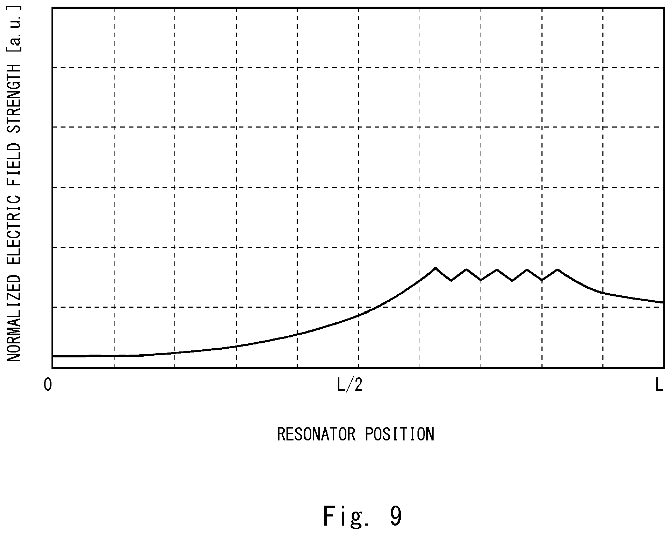

Fig. 9 shows an example of a calculation result of an electric field strength distribution of a light in the DFB laser 200 according to the second embodiment. When the configuration in which one phase shift part is disposed (Fig. 13) is compared with the configuration in which five phase shift parts are disposed, like in the DFB laser 100 according to the first embodiment (Fig. 2), it can be understood that the peak of the electric field strength is further reduced. While Fig. 9 shows the calculation result when kL is 2.1, the value of kL is not particularly limited. Also in the range of 1≤kL≤4, the result of suppressing the electric field strength at the position of each phase shift part can be obtained.

As described above, according to this configuration, the concentration of the electric field strength of the light can be suppressed by increasing the number of phase shift parts to be disposed. Thus, even when a large current is flowed in the distributed feed back semiconductor laser having a short resonator length, an element capable of obtaining stable single-mode characteristics, reducing random failures, and having a long life can be obtained.

### Third Embodiment

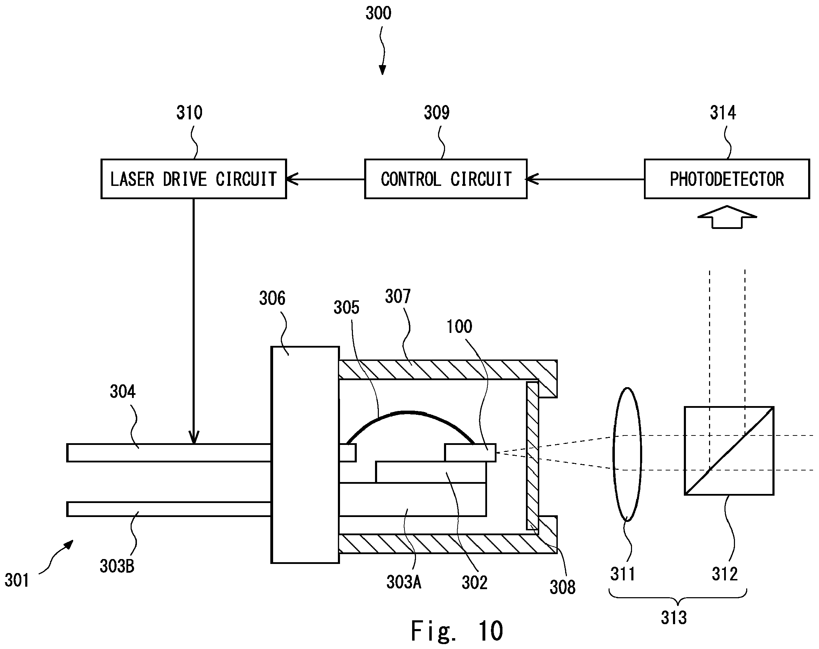

A light source unit 300 according to a third embodiment will be described. The light source unit 300 is configured as a light source unit in which the DFB laser 100 according to the first embodiment described above is used as a light source. Fig. 10 is a diagram schematically showing the configuration of the light source unit 300 according to the third embodiment.

As shown in Fig. 10, in the DFB laser 100, a mounting part 303A projects into a CAN package 301 from a disc-shaped metal stem 306 of the CAN package 301. A heat sink 302 is mounted on the mounting part 303A, and the DFB laser 100 is mounted on the heat sink 302.

A bar-like lead part 303B projects from the back surface of the metal stem 306 in a direction perpendicular to the back surface of the metal stem 306. Further, a terminal 304 which penetrates through the central part of the metal stem 306 is fixed so as to extend in the direction perpendicular to the back surface of the metal stem 306. One end of the terminal 304 which projects into the CAN package 301 is electrically connected to the DFB laser 100 through a wire 305.

A cap 307 which has a cylindrical shape and is made of metal is joined to the front surface of the metal stem 306. Thus, the DFB laser 100, the heat sink 302, the mounting part 303A, an end of the terminal 304, and the wire 305 are covered with the cap 307. Further, an opening is formed in a light exit part of the cap 307, and a cover glass 308 through which light penetrates from the DFB laser 100 is attached to the opening.

Such a semiconductor laser device is mounted on, for example, an optical communication instrument or a precision measuring instrument, as a light source, thereby obtaining an advantageous effect of achieving performance improvements (such as an increase in speed and an improvement in reliability) of instruments by obtaining a high output, a high efficiency, stable single-mode characteristics, which can be obtained even when a large current is flowed, and a long element life.

A control circuit 309 controls a laser drive circuit 310 as appropriate, and the laser drive circuit 310 applies a drive voltage to the terminal 304, so that the DFB laser 100 oscillates the laser.

Laser light emitted from the DFB laser 100 passes through an optical system 313, which is formed of, for example, a lens 311 and a beam splitter 312, and is output from the light source unit 300. In this case, the laser light transmitted through the beam splitter 312 is output to the outside of the light source unit 300, and a part of the laser light reflected by the beam splitter 312 is incident on a photodetector 314. The photodetector 314 detects the intensify of the incident laser light, and outputs the detection result to the control circuit 309. Thus, the control circuit 309 can perform a feedback control in such a manner that the intensity of the laser light emitted from the DFB laser 100 falls within a desired range, by referring to the detection result from the photodetector 314.

As described above, according to this configuration, the light source unit using the semiconductor lasers according to the embodiments described above can be configured. The light source unit according to the third embodiment is mounted on, for example, an optical communication instrument or a precision measuring instrument, thereby achieving performance improvements (such as an increase in speed and an improvement in reliability) of instruments by obtaining a high output, a high efficiency, stable single-mode characteristics, which can be obtained even when a large current is flowed, and a long element life.

### Fourth Embodiment

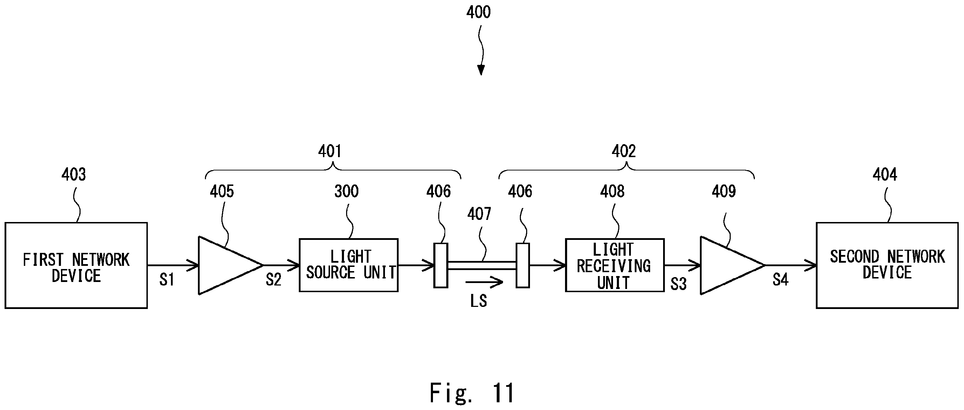

An optical communication system 400 according to a fourth embodiment will be described. The optical communication system on which the light source unit 300 according to the third embodiment is mounted will be described. Fig. 11 is a diagram schematically showing the configuration of the communication system 400 according to the fourth embodiment.

As shown in Fig. 11, the optical communication system 400 includes a transmitter 401, a receiver 402, a first network device 403, a second network device 404, and an optical fiber 407. The transmitter 401 includes the light source unit 300, a drive circuit 405, and an optical connector 406. The receiver 402 includes a light receiving unit 408, a reception circuit 409, and the optical connector 406.

When an electric signal S1 is input to the transmitter 401 from the first network device 403, an electric signal S2 is input to the light source unit 300 through the drive circuit 405, and a light signal LS is generated. The light signal LS transmitted by the optical fiber 407 through the optical connector 406, which is composed of a lens or the like, and is input to the receiver 402. After that, the light signal LS is input to the light receiving unit 408, which is composed of a photodiode or the like, through the optical connector 406 located closer to the receiver 402, and becomes an electric signal S3. This electric signal is output to the second network device 404 as an electric signal S4 through the reception circuit 409, thereby establishing optical communication between the first network device 403 and the second network device 404.

As described above, according to this configuration, the optical communication system using the light source unit according to the above embodiment can be configured. The light source unit 300 described above has a high output, a high efficiency, stable single-mode characteristics, which can be obtained even when a large current is flowed, and a long element life, and thus a reduction in power consumption and an increase in reliability of the optical communication system can be achieved.

### Fifth Embodiment

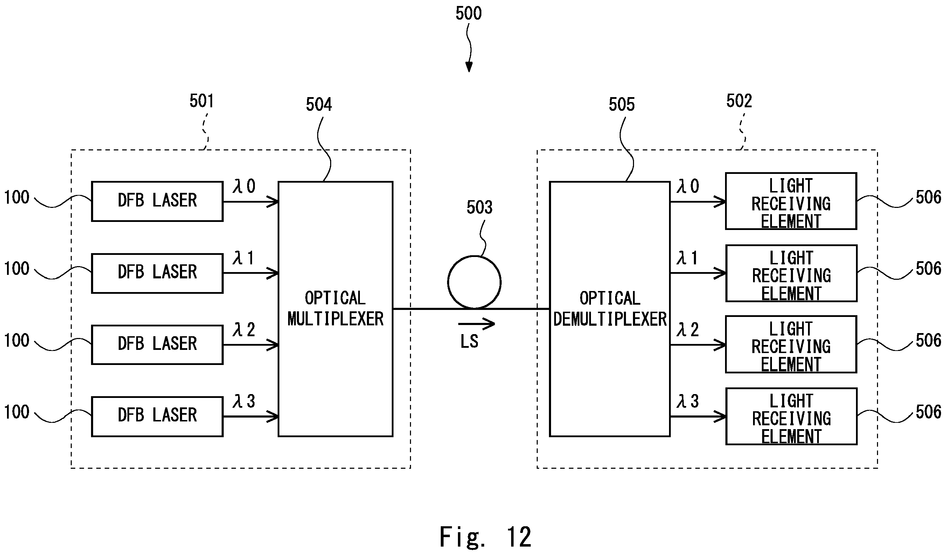

A wavelength division multiplexing optical communication system 500 according to a fifth embodiment will be described. The wavelength division multiplexing optical communication system 500 according to the fifth embodiment uses the DFB lasers according to the embodiments described above. Fig. 12 schematically shows the wavelength division multiplexing optical communication system according to the fifth embodiment. The wavelength division multiplexing optical communication system 500 includes a transmitter 501, a receiver 502, and an optical fiber 503.

The transmitter 501 includes a plurality of DFB lasers 100 and an optical multiplexer 504. The plurality of DFB lasers 100 each receive input signals from a drive circuit and the like, and output light signals (λ0, λ1, λ2, ...) having different wavelengths. These light signals (as indicated by reference symbol LS in Fig. 12) are output from the optical multiplexer 504 and input to the receiver 502 through a single optical fiber 503.

The receiver 502 includes an optical demultiplexer 505 and a plurality of light receiving elements 506. The optical demultiplexer 505 demultiplexes the plurality of input light signals (as indicated by reference symbol LS in Fig. 12) are split into the light signals (λ0, λ1, λ2, ...) having different wavelengths, and the light receiving element 506 converts the light signals into electric signals.

As described above, according to this configuration, the wavelength division multiplexing optical communication system using the DFB lasers according to the embodiments described above can be configured. Further, the DFB laser 100 has a high output, a high efficiency, stable single-mode characteristics, which can be obtained even when a large current is flowed, and a long element life, and thus a reduction in power consumption and an increase in reliability of the wavelength division multiplexing optical communication system can be achieved.

Note that the present invention is not limited to the embodiments described above, and can be modified as appropriate without departing from the scope of the invention. For example, the embodiments described above illustrate examples of the distributed feed back semiconductor laser that is used in a 1.3 µm band or a 1.5 µm band and formed of an InP-based material or the like. The present invention can also be applied to, for example, distributed feed back semiconductor lasers based on other compound semiconductor such as a GaAs system or a GaN system, as a material system. As for the wavelength band, other wavelength bands may be used.

The embodiments described above illustrate an embedded-type distributed feedback semiconductor laser. However, the structure described in the embodiments described above can also be applied to, for example, distributed feed back semiconductor lasers having other structures, such as a ridge stripe type laser.

Further, the embodiments described above illustrate the layer structure of semiconductor lasers, but the present invention is not limited to this example. Other layers may be added, or some of layers may be removed, as long as the present invention operates as a semiconductor laser. Furthermore, the conductivity types of the semiconductor layers may be reversed.

For example, in the embodiments described above, the conductivity type (p-type or n-type) of the substrate, the guide layer, an active layer, the clad layer and the like may be reversed. Accordingly, when one of the conductivity types of the n-type and the p-type is defined as a first conductivity type and the other conductivity type is defined as a second conductivity type, the first conductivity type may be the p-type and the second conductivity type may be the n-type. On the contrary, the first conductivity type may be the n-type and the second conductivity type may be the p-type.

The invention made by the present inventors has been described in detail above based on the embodiments. However, the present invention is not limited to the embodiments described above, and can be modified in various ways without departing from the scope of the invention.

The first to fifth embodiments can be combined as desirable by one of ordinary skill in the art.

While the invention has been described in terms of several embodiments, those skilled in the art will recognize that the invention can be practiced with various modifications within the spirit and scope of the appended claims and the invention is not limited to the examples described above.

Further, the scope of the claims is not limited by the embodiments described above.

Furthermore, it is noted that, Applicant's intent is to encompass equivalents of all claim elements, even if amended later during prosecution.

## Claims

1. A distributed feed back semiconductor laser comprising:
a first resonator end surface;
a second resonator end surface having a higher reflectance than that of the first resonator end surface; and
a diffraction grating formed so as to extend in a guiding direction of a resonator between the first resonator end surface and the second resonator end surface,
wherein a plurality of phase shift parts configured to discontinuously change a phase of the diffraction grating are disposed in a predetermined region separated from the first resonator end surface in the diffraction grating.

2. The distributed feed back semiconductor laser according to Claim 1, wherein the predetermined range is a range between the second resonator end surface and a center of the resonator in the guiding direction.

3. The distributed feed back semiconductor laser according to Claim 2, wherein the predetermined range is a range between a position separated from the first resonator end surface by a distance obtained by multiplying 0.5 by a length of the resonator in the guiding direction, or more, and a position separated from the first resonator end surface within a distance obtained by multiplying 0.9 by the length of the resonator in the guiding direction.

4. The distributed feed back semiconductor laser according to Claim 1, wherein the number of the phase shift parts is an odd number in a range from 3 to 13.

5. The distributed feed back semiconductor laser according to Claim 1, wherein when an oscillation wavelength is represented by λ, a phase shift of each of the phase shift parts is λ/4.

6. The distributed feed back semiconductor laser according to Claim 1, wherein a value kL obtained by multiplying a coupling coefficient k by a length L of the resonator in the guiding direction is in a range from 1 to 4.

7. The distributed feed back semiconductor laser according to Claim 1, wherein the length of the resonator in the guiding direction is equal to or less than 200 µm.

8. A light source unit comprising the distributed feed back semiconductor laser according to Claim 1.

9. An optical communication system comprising the light source unit according to Claim 8.

10. A wavelength division multiplexing optical communication system comprising the distributed feed back semiconductor laser according to Claim 1.
